# FASCICULE DE BREVET EUROPEEN

(11) **EP 1 856 955 B1**
(45) Date de publication et mention de la délivrance du brevet: **06.11.2019**
(21) Numéro de dépôt: 05823018.6
(22) Date de dépôt: 29.11.2005
(51) Int. Cl.: H05K 7/20

(54) **PROCEDE DE REFROIDISSEMENT D'UN DISPOSITIF DE CONVERSION STATIQUE D'ELECTRONIQUE DE PUISSANCE ET DISPOSITIF CORRESPONDANT**
VERFAHREN ZUM KÜHLEN EINER STATISCHEN ELEKTRONISCHEN LEISTUNGSWANDLEREINRICHTUNG UND ENTSPRECHENDE EINRICHTUNG
METHOD FOR COOLING A STATIC ELECTRONIC POWER CONVERTER DEVICE AND CORRESPONDING DEVICE

(30) Priorité: 19.01.2005 FR 0500528; 08.02.2005 US 650794 P
(43) Date de publication de la demande: 21.11.2007
(73) Titulaire: Intelligent Electronic Systems (IES), 34130 Saint-Aunes (FR)
(72) Inventeur: MARCHAND, Roger, F-34000 Montpellier (FR)
(74) Mandataire: Bandpay & Greuter
(86) Numéro de dépôt international: PCT/FR2005/002958
(87) Numéro de publication internationale: WO 2006/077288

(56) Documents cités:
- WO-A-00/27176
- DE-A1- 3 347 854
- FR-A1- 2 544 159
- US-A- 6 081 425
- US-A1- 2002 118 509

## Description

La présente invention concerne un procédé de refroidissement de dispositif de conversion statique d'énergie électrique et un dispositif de conversion statique correspondant utilisant ce procédé de refroidissement.

Le domaine technique de l'invention est celui de la conception et de la fabrication de systèmes d'électronique de puissance, notamment de convertisseurs d'énergie électrique installés, de façon permanente ou non, dans des ensembles mécaniques et/ou électriques plus importants dont ils participent au fonctionnement.

De tels dispositifs de conversion d'énergie électrique s'appliquent notamment aux chargeurs de batteries embarqués pour l'alimentation en énergie électrique de véhicules et d'engins électriques tels que les chariots de transport de marchandises, les nacelles élévatrices ou encore les petits véhicules de transport comme des voiturettes de golf.

Les convertisseurs statiques du type décrit ci-dessus, par exemple les chargeurs de batteries embarqués, comportent des circuits électroniques composés de divers composants électriques actifs (transistors Mos, diodes) et passifs (transformateurs, condensateurs, inductances, résistances) disposés à l'intérieur de boîtiers métalliques de protection. Lors du fonctionnement des convertisseurs, lesdits composants chauffent lorsqu'ils sont traversés par le courant électrique, ce qui provoquent une élévation de leur température pouvant aller jusqu'à plusieurs dizaines de degrés Celsius, causant parfois la destruction desdits composants.

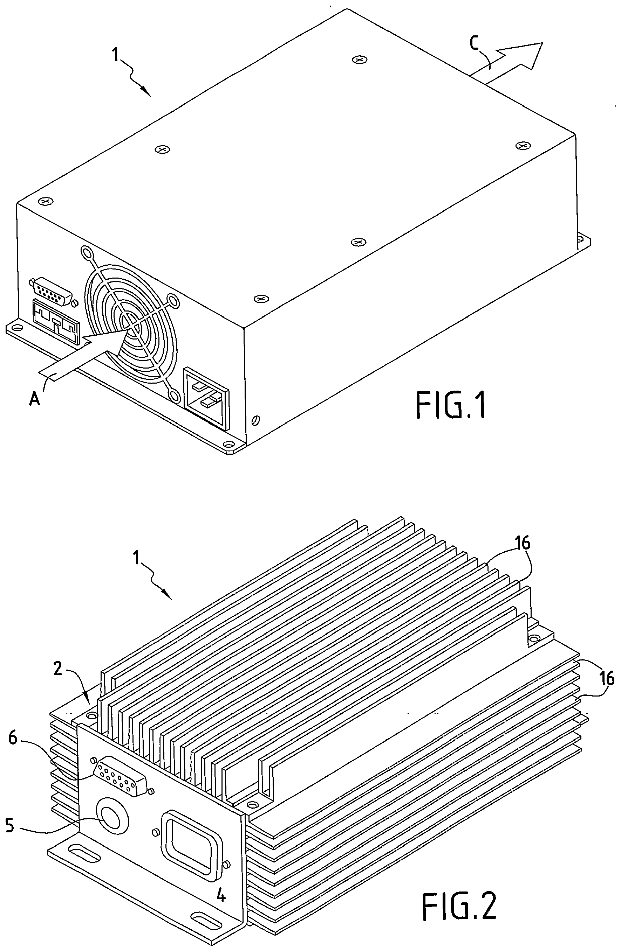

Les convertisseurs embarqués utilisés à l'heure actuelle, dont un exemple est représenté à la figure 1, sont refroidis par ventilation forcée à l'aide d'un ventilateur. Le boîtier 1 est ouvert en deux endroits dans le sens de la longueur, permettant l'introduction d'air "frais" A à une première extrémité, la circulation de l'air et l'extraction de l'énergie calorifique dégagée par les composants électriques vers l'extérieur de celui-ci, l'air "chaud" C étant évacué par l'autre extrémité ouverte du boîtier.

Un tel procédé de refroidissement est tout à fait satisfaisant en terme de mise en œuvre et de rendement énergétique. Cependant, certains inconvénients subsistent en terme de protection des circuits électroniques des convertisseurs du fait de l'existence des ouvertures de circulation d'air nécessaires au refroidissement des composants. En effet, ces ouvertures favorisent l'introduction de poussières et autres particules solides ou liquides qui se déposent sur les circuits électroniques à l'intérieur du boîtier des convertisseurs. Vus les conditions d'utilisations et d'entretien de plus en plus sévères des engins dans lesquels les convertisseurs sont embarqués (projections de terre, de sable, de boue ou d'eau, nettoyage haute-pression), les fabricants et utilisateurs de ces engins ont exprimé un besoin grandissant pour des convertisseurs qui soient entièrement étanches aux poussières et projections de matières solides ou liquides diverses qui dégradent les convertisseurs actuels ouverts vers l'extérieur et refroidis par ventilation forcée (figure 1), voir les détruisent.

Parallèlement, lesdits fabricants et utilisateurs d'engins et véhicules électriques requièrent que de tels convertisseurs étanches leurs soient fournis à un prix sensiblement équivalent à celui des convertisseurs refroidis par convection forcée, ce qui ne permet pas d'envisager des solutions techniques coûteuses, connues par exemple de l'industrie aéronautique, pour réaliser des convertisseurs statiques d'électronique de puissance étanches qui répondent à leurs besoins.

Les documents DE 3347854 A1 et FR 2544159 A1 décrivent une boîte pour un dispositif convertisseur de courant comportant un ventilateur dans l'espace fermé de la boîte, disposé sur un support pour plaques à circuits imprimés.

La présente invention vise à remédier aux inconvénients des convertisseurs statiques d'électronique de puissance connus en proposant un nouveau procédé de refroidissement permettant d'étanchéifier de tels convertisseurs.

La présente invention a également pour objectif de fournir un convertisseur statique d'électronique de puissance étanche utilisant le procédé de refroidissement de l'invention, dont la structure ne présente que des légères modifications par rapport aux convertisseurs actuels, et dont le coût de revient soit par conséquent équivalent.

La présente invention remplit ses objectifs, conformément à un premier objet, en proposant un procédé selon la revendication 1 de refroidissement d'un dispositif de conversion statique d'électronique de puissance comportant au moins un circuit électrique comprenant un assemblage de composants actifs et de composants passifs reliés entre eux d'une façon adaptée à la réalisation d'une fonction déterminée de conversion d'énergie électrique, ledit circuit comportant des moyens d'entrée de l'énergie électrique à convertir et des moyens de sortie de l'énergie électrique convertie et étant monté dans un boîtier radiateur fermé duquel seuls lesdits moyens d'entrée et de sortie dudit circuit communiquent avec l'extérieur dudit boîtier, caractérisé en ce que l'on homogénéise la répartition de l'énergie calorifique dégagée par lesdits composants actifs et passifs dans tout le volume interne dudit boîtier et l'on transfère ladite énergie calorifique au dit boîtier radiateur par convection forcée de façon sensiblement uniforme sur toute la surface interne des parois dudit boîtier par circulation en circuit fermé d'au moins un fluide contenu à l'intérieur dudit boîtier étanche.

Par cette homogénéisation de la répartition de chaleur à l'intérieur du boîtier du convertisseur, le procédé de l'invention permet de façon avantageuse de supprimer les points chauds sur la surface du boîtier du convertisseur et ainsi de diminuer la résistance thermique entre les composants et le boîtier de façon suffisante pour transmettre à celui-ci et évacuer l'énergie calorifique des composants électriques. On a en effet découvert que, de façon surprenante, la convection par un fluide au contact des composants à refroidir et des parois du boîtier suffit à évacuer l'énergie calorifique dégagée par les composants lors du fonctionnement du convertisseur. Le fluide en circulation forcée dans le boîtier joue ainsi le rôle d'échangeur thermique homogène entre les composants, en particulier les composants passifs, et le boîtier.

On peut de la sorte réaliser un convertisseur fermé de façon étanche aux particules liquides et solides autour des circuits électroniques du convertisseur.

Selon une caractéristique préférée du procédé selon l'invention, on canalise ledit fluide vis-à-vis desdits composants actifs et passifs et desdites parois internes du boîtier. On peut de cette façon guider le fluide autour de l'ensemble des composants ou uniquement de certains ainsi qu'éviter la stagnation du fluide dans certains recoins du boîtier, ce qui améliore encore l'homogénéisation des calories des composants à l'intérieur du boîtier.

Conformément à une autre caractéristique préférée, on fait varier la vitesse de circulation du fluide à l'intérieur du boîtier en fonction de l'énergie calorifique dégagée par lesdits composants et/ou en fonction du volume interne dudit boîtier radiateur. Par cette variation de la vitesse du fluide à l'intérieur du boîtier, il est possible de contrôler le transfert thermique afin de respecter les normes de sécurité de fonctionnement des convertisseurs, qui spécifient des valeurs limites de températures du boîtier.

Dans la configuration la plus simple, le boîtier radiateur définit un compartiment unique clos autour de l'électronique du dispositif de conversion. Toutefois il est parfois préférable, dans un mode de mise en œuvre particulier et avantageux du procédé de l'invention, de faire circuler ledit fluide entre au moins deux compartiments délimités à l'intérieur dudit boîtier.

Selon une autre caractéristique avantageuse du procédé de l'invention, on créée une différence de pression de fluide entre lesdits compartiments de manière à favoriser la circulation de celui-ci à l'intérieur du boîtier et augmenter le transfert d'énergie calorifique vers les parois dudit boîtier.

Un autre objet de l'invention est de fournir un dispositif de conversion statique d'électronique de puissance selon la revendication 6 refroidi selon le procédé de l'invention, en particulier du type comportant au moins un circuit électrique comprenant un assemblage de composants actifs et de composants passifs reliés entre eux d'une façon adaptée à la réalisation d'une fonction déterminée de conversion d"énergie électrique, ledit circuit comportant des moyens d'entrée de l'énergie électrique à convertir et des moyens de sortie de l'énergie électrique convertie et étant monté dans un boîtier radiateur duquel seuls lesdits moyens d'entrée et de sortie dudit assemblage communiquent avec l'extérieur dudit boîtier.

Le dispositif de l'invention se caractérise par le fait que ledit boîtier renferme au moins un fluide dans lequel baigne ledit assemblage de composants, et en ce qu'il comporte en outre au moins un moyen de propulsion et de circulation dudit fluide en circuit fermé à l'intérieur dudit boîtier.

Ce convertisseur présente l'avantage d'être entièrement étanche aux particules solides et liquides, le boîtier étant entièrement clos autour des circuits électroniques de conversion et de leurs composants. Un tel convertisseur est donc utilisable sans risques de dégradations dues aux dépôts d'humidité ou de poussières suite à des projections en cours d'utilisation ou d'entretien des engins à l'intérieur desquels ces convertisseurs sont embarqués.

En outre, les coûts de revient d'un tel convertisseur sont semblables à ceux des convertisseurs à refroidissement classique.

Dans un mode de réalisation avantageux, le dispositif de l'invention comporte également le cas échéant un drain thermique entre le(s) composant(s) dudit circuit électrique et ledit boîtier.

Un tel drain thermique, par exemple constitué d'une résine conductrice chargée permet d'isoler électriquement certains composants électriques et de drainer l'énergie dissipée par ceux-ci directement vers le boîtier, notamment pour certains composants magnétiques à forte déperdition calorifique comme les transformateurs, améliorant ainsi encore l'évacuation de chaleur vers l'extérieur du convertisseur.

Préférentiellement, le fluide contenu dans le boîtier du dispositif est un liquide tel que de l'huile ou un gaz tel que de l'air apte à permettre le fonctionnement dudit circuit, ledit boîtier étant étanche au dit fluide autour dudit circuit électrique. Bien que connus pour être de mauvais conducteurs thermique, de tels fluides sont particulièrement adaptés pour permettre la réalisation de convertisseur refroidis selon le procédé de l'invention, l'air étant toutefois privilégié pour sa gratuité et la plus grande simplicité de mise en œuvre pour la réalisation des convertisseurs.

Dans un mode de réalisation privilégié, ledit moyen de propulsion du fluide comporte au moins une hélice couplée à un moteur électrique relié au dit circuit électrique du dispositif. Un tel moyen de propulsion pourra être avantageusement un petit ventilateur, dont les caractéristiques et la position dans le convertisseur seront choisis en fonction des caractéristiques de fonctionnement de ce dernier.

Le dispositif selon l'invention comporte des moyens de canalisation dudit fluide à l'intérieur dudit boîtier. On comprend ici aisément que de tels moyens de canalisation permettent le guidage du flux d'air ou d'huile à l'intérieur du boîtier et ainsi améliorent la circulation du fluide ainsi que la répartition des calories à évacuer au contact des parois dudit boîtier.

Le dispositif comporte également au moins deux moyens de propulsion disposés de façon à améliorer/accélérer la circulation du fluide à l'intérieur dudit boîtier, des moyens de cloisonnement du boîtier étant positionnés au moins entre lesdits moyens de propulsions.

Afin d'améliorer l'évacuation de l'énergie calorifique dégagée par les composants électriques de l'intérieur vers l'extérieur du dispositif, on privilégiera un boîtier dont la surface intérieure et/ou extérieure dudit boîtier comporte des moyens de dissipation d'énergie calorifique tels que des ailettes.

D'autres caractéristiques de l'invention ressortiront à la lecture de la description détaillée faite ci-après, en référence aux dessins annexés qui montrent, à titre d'exemples non limitatifs une forme de réalisation privilégiée de l'appareil selon l'invention, pour la mise en œuvre du procédé selon l'invention, **ainsi que d'autres variations non revendiquées**.
- la figure 1 représente un chargeur de batterie connu de l'art antérieur;
- la figure 2 représente en perspective le boîtier d'un chargeur de batterie conforme à la présente invention;
- la figure 3 représente fonctionnellement la structure électronique d'un chargeur de batterie du type de ceux auxquels s'appliquent la présente invention;
- la figure 4 représente une vue éclatée d'un chargeur de batterie;
- la figure 5 représente schématiquement un chargeur de batterie;
- la figure 6 représente schématiquement un chargeur de batterie selon l'invention;
- la figure 7 représente schématiquement un chargeur de batterie;
- la figure 8 représente schématiquement un chargeur de batterie selon l'invention.

Le procédé de l'invention s'applique particulièrement au refroidissement de chargeurs de batterie pour véhicules électriques de type nacelles ou chariots élévateurs dont un exemple de réalisation particulier est donné ci-après.

En référence aux figures 2 à 4 dans un premier temps, un tel chargeur de batterie 1 est constitué par un convertisseur statique d'électronique de puissance (courant alternatif/courant continu) comprenant un boîtier externe métallique 2 à l'intérieur du quel est renfermé la structure électronique du convertisseur 3.

Le boîtier externe 2 est constitué de plaques métalliques rectangulaires 21, 22, 23, 24 formant, respectivement, le fond, le capot et les parois latérales du boîtier, ces plaques étant fixées les unes aux autres par tout moyen approprié, tel que par exemple soudure ou, comme dans l'exemple représenté, par vissage au niveau des extrémités longitudinales de chaque plaque. D'une autre façon il peut également être constitué d'un tube extrudé par une filiaire. Des flasques 25, 26 de dimensions appropriées obturent les ouvertures délimitées entre les plaques aux extrémités longitudinales du boîtier, lesdits flasques comportant des ouvertures 251, 252 découpées permettant le passage de connecteurs d'alimentation 4, 5 de la structure électronique renfermée à l'intérieur du boîtier, ainsi qu'au moins un connecteur de communication 6 avec un système de programmation.

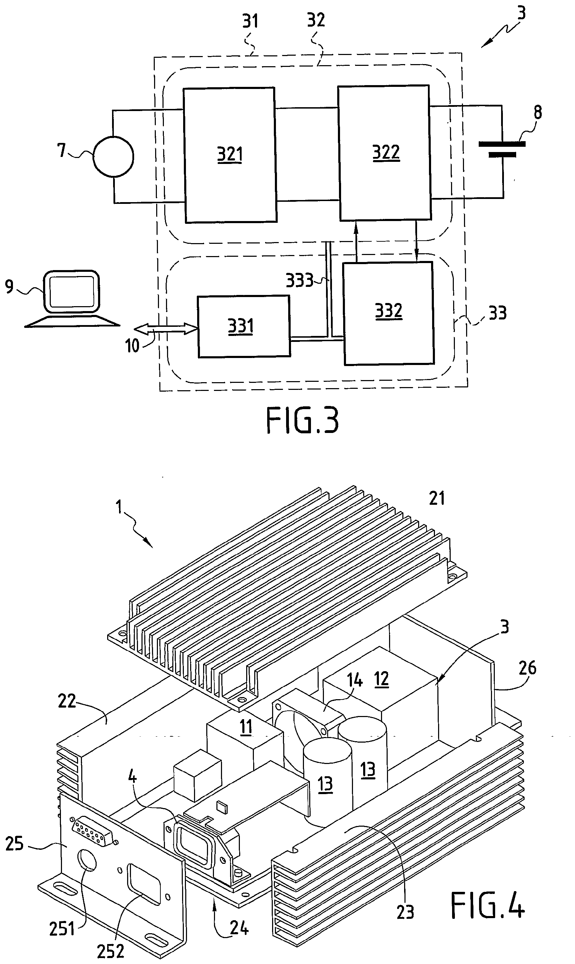

Ladite structure électronique 3, représentée fonctionnellement à la figure 3 et structurellement sur la figure 4, est constituée d'une carte électronique 31 supportant l'ensemble des composants et des circuits électriques constituant le convertisseur d'électronique de puissance du chargeur 1.

Ce convertisseur, de type classique, peut être par exemple constitué d'un pont redresseur monophasé 321 suivi d'un hacheur 322 à pont complet ZVS (Zero Voltage Switching) dont la sortie est isolée par un transformateur haute fréquence. Ce redresseur suivi hacheur constitue l'étage de puissance 32 du convertisseur, lequel est apte à être alimenté en entrée par une source de courant électrique alternatif 7 pour délivrer en sortie un courant électrique continu permettant le chargement d'une batterie 8 d'un engin à charger.

En complément, comme représenté sur la figure 3, la carte électronique 3 supporte également un étage de contrôle 33 de cet étage de puissance 32, comprenant une mémoire 331 et un microcontrôleur 332 de régulation du courant et de la tension de sortie du convertisseur par l'intermédiaire d'un bus de donnée 333 reliant ladite mémoire et ledit microcontrôleur au dit étage de puissance.

Cet étage de contrôle permet notamment le réglage des paramètres de fonctionnement de l'étage de puissance 32 afin de respecter les caractéristiques nominales de tension et de courant délivrés par le chargeurs, lesquelles peuvent être par exemple dans le cas du chargeur décrit de 24 volts et 15 ampères. Toutefois, d'autres valeurs de tension et de courant nominaux peuvent être également réglées.

En effet, il suffit pour régler ces paramètres de connecter ledit chargeur 1 à un - système numérique de programmation 9, par l'intermédiaire d'un bus de commande 10 reliant ledit système numérique audit étage de contrôle via un connecteur sur le boîtier du chargeur. De tels moyens de réglage des paramètres de fonctionnement du chargeur à l'aide d'un système numérique de programmation étant connus de l'homme du métier, ceux-ci ne seront pas développés plus avant dans la présente demande.

Conformément à l'invention, l'intégralité de la structure électronique 3 du chargeur, est confinée à l'intérieur du boîtier métallique 2 de celui-ci, lequel est intégralement fermé, de préférence de façon étanche à toute projection de matière liquide ou solide pouvant endommager la structure électronique du convertisseur et dégrader ainsi, voire détruire, le chargeur et empêcher son fonctionnement. Un tel boîtier fermé, permet d'augmenter l'indice de protection du chargeur, mais ne permet plus la circulation d'air de l'extérieur vers l'intérieur du boîtier pour refroidir les composants électriques, comme avec les chargeurs refroidis par convection forcée tels que représentés à la figure 1, et seul le boîtier métallique du chargeur permet alors d'évacuer l'énergie calorifique dégagée par les composants électriques lors du fonctionnement du chargeur, par cette énergie calorifique correspondant aux pertes du chargeur.

Les principaux composants à refroidir sont des composants passifs de type inductances 11, transformateurs 12 et condensateurs 13, mais également des composants actifs tels des diodes ou transistors Mos de puissance. De façon connue, les composants actifs sont, de préférence, directement placés en contact avec le boîtier afin de transmettre la chaleur qu'il dégage directement à celui-ci par conduction.

En revanche, les composants passifs, notamment les composants magnétiques (inductances 11, transformateurs 12, condensateurs 13) ne le sont pas. Ces composants ayant une résistance thermique élevée, souvent supérieure à 10°C/W, l'élévation de température à l'intérieur du boîtier due au dégagement de chaleur par ces composants en fonctionnement est très importante, en pratique de l'ordre de cinq à plusieurs dizaines de degrés, ce qui risque de les détruire s'ils ne sont pas refroidis.

C'est pourquoi, conformément à l'invention, le chargeur 1 comporte deux ventilateurs placés à l'intérieur du boîtier fermé, permettant de créer une circulation d'un flux d'air 15 en circuit fermé, au contact des composants à refroidir ainsi que des parois internes du boîtier.

Ce flux d'air 15 permet d'homogénéiser la répartition de l'énergie calorifique dégagée par lesdits composants 11, 12, 13, à l'intérieur du boîtier 2 et de diminuer de façon importante la résistance thermique entre les composants passifs et les parois du boîtier, ce qui permet de réduire de façon substantielle la température de fonctionnement de ces composants, par convection de l'énergie qu'ils dégagent via le flux d'air circulant en circuit fermé sous l'effet des ventilateurs vers les parois de boîtier.

Ledit boîtier remplit alors la fonction d'un radiateur de chaleur et c'est pourquoi les parois externes, et le cas échéant internes, des plaques métalliques 21, 22, 23, 24 formant celui-ci comportent des ailettes de refroidissement 16.

Les ventilateurs sont positionnés sur la carte électronique 3 supportant les composants à refroidir et sont reliés au circuit électrique de ladite carte, ainsi que, de préférence, à l'étage de contrôle 33 du convertisseur de façon à permettre, via cet étage, le réglage des paramètres de fonctionnement des ventilateurs en fonction des paramètres de fonctionnement et des paramètres structurels du chargeur. Comme lesdits paramètres de fonctionnement du chargeur, les paramètres de fonctionnement des ventilateurs sont aisément programmables et ajustables par l'intermédiaire du système numérique de programmation du chargeur évoqué ci-avant.

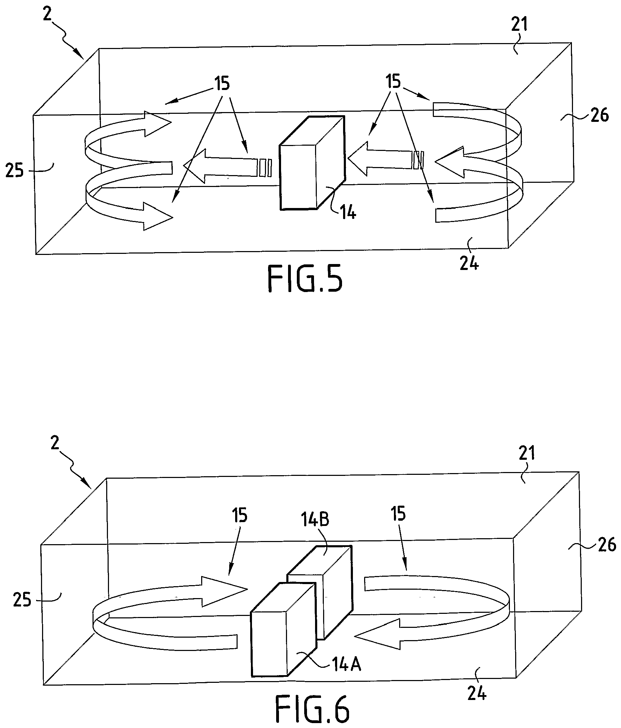

Suivant la configuration de la carte électronique 3 enfermée à l'intérieur du boîtier 2 du chargeur et de la place disponible sur celle-ci, plusieurs configurations peuvent être envisagées pour générer et faire circuler un flux d'air 15 servant à refroidir les composants à l'intérieur de ce boîtier. Ces différentes configurations, revendiquées et non revendiquées, sont représentées schématiquement aux figures 5 à 8.

Ainsi, comme représenté à la figure 5, un ventilateur 14 peut être positionné de façon centrale sur la carte électronique 3 du chargeur de façon à générer un flux d'air 15 central se déplaçant longitudinalement à l'intérieur du boîtier et se répartissant sur les flasques 25, 26 et les parois latérales du boîtier, générant de la sorte, une circulation de flux d'air forcé à l'intérieur du boîtier par aspiration puis projection de l'air contenu dans ce boîtier contre les parois de celui-ci.

Dans un mode de réalisation représenté à la figure 6, la circulation du flux d'air 12 à l'intérieur du boîtier du chargeur est provoquée et entretenue par l'intermédiaire de deux ventilateurs 14A, 14B disposés sensiblement au milieu de la carte électronique 3 dans le sens de sa longueur et sur les bords latéraux de celle-ci, l'espace entre les deux ventilateurs étant cloisonné par une paroi empêchant ainsi la circulation entre les dits ventilateurs, l'air aspiré et projeté par un premier ventilateur 14A se réfléchissant sur un premier flasque d'extrémité 25 du boîtier et étant ensuite aspiré puis projeté par le second ventilateur 14B générant ainsi une boucle de circulation continue, régulière et homogène à l'intérieur du boîtier 2.

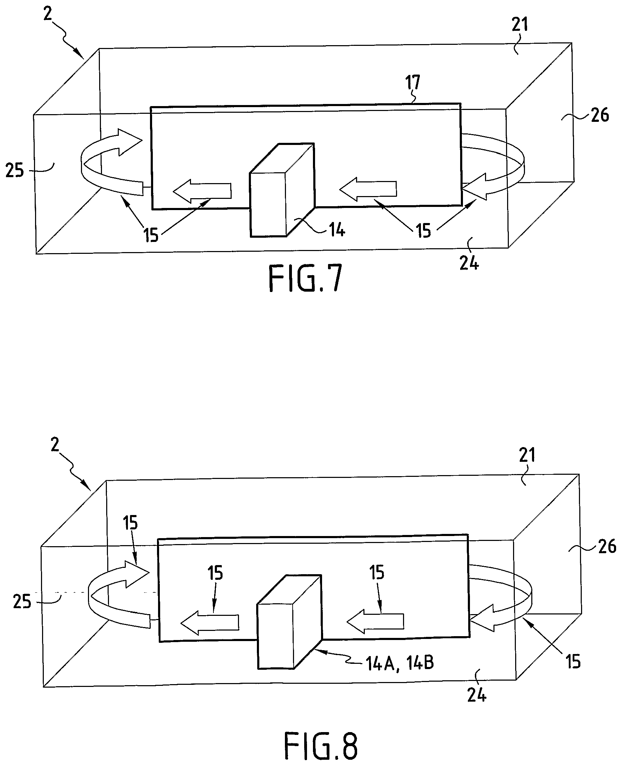

Dans une configuration comportant également deux ventilateurs représentés à la figure 8, on dispose entre les deux ventilateurs latéraux 14A, 14B, un cloisonnement 17 dirigé longitudinalement à l'intérieur du boîtier, ce cloisonnement 17 permettant un guidage amélioré du flux d'air 15 au contact des composants électriques ainsi que des parois du boîtier. De plus, un tel cloisonnement permet de générer des turbulences du flux et donc des différences de pression entre les différentes zones du boîtier délimitées par ce cloisonnement, ces turbulences et différences de pression améliorant l'échange d'énergie entre le flux d'air et le boîtier et donc la dissipation de chaleur vers l'extérieur de celui-ci.

Comme représenté maintenant à la figure 7, un tel cloisonnement longitudinal 17 à l'intérieur du boîtier peut également être envisagé lorsqu'un seul ventilateur 14, disposé latéralement sur la carte électronique, est employé pour refroidir les différents composants électroniques. Dans ce cas, la vitesse du flux d'air de part et d'autre du cloisonnement est variable.

Dans tous les modes de réalisation et variations non revendiquées décrits précédemment, les différents paramètres critiques permettant de diminuer la température de fonctionnement des composants électroniques passifs, sont:
- la position du ou des ventilateurs 14, 14A, 14B
- la vitesse du flux d'air 15,
- la nature et la géométrie de la surface intérieure et extérieure des parois 21, 22, 23, 24, 25, 26 du boîtier, et
- la position et la géométrie de la cloison 17 lorsque celle-ci est présente.

L'énergie calorifique théorique dégagée par les composants en fonctionnement étant déductible à partir des caractéristiques intrinsèques connues desdits composants, des caractéristiques de fonctionnement du chargeur, il suffit de choisir ensuite les paramètres de fonctionnement du ventilateur, déterminant la vitesse du flux d'air; et la géométrie des parois du boîtier, notamment la taille et le nombre des ailette de refroidissement, en fonction de l'énergie calorifique à extraire du chargeur et des contraintes normatives de fonctionnement de tels chargeurs et autres types de convertisseurs, la position du ventilateur et des éventuelles cloisons étant elles déterminées par la configuration interne du boîtier 2 ainsi que le positionnement des composants sur la carte électronique 31.

De façon avantageuse on peut également prévoir, pour certains composants critiques thermiquement comme le transformateur 12, de disposer un drain thermique entre celui-ci et le boîtier 2 afin d'évacuer l'énergie calorifique vers l'extérieur directement par conduction, tout en respectant les règles d'isolation électrique. Un tel drain thermique peut, par exemple, être constitué d'une enveloppe à base de résine de silicone chargée disposée sur la bobine du transformateur entre celle-ci et le boîtier radiateur 2 du chargeur.

Selon une autre caractéristique avantageuse de l'invention, on peut également prévoir des moyens de réglage dynamique des paramètres de fonctionnement du ou des ventilateurs 14, 14A, 14B, et ainsi de la vitesse de circulation du flux d'air. De tels moyens de réglage peuvent par exemple comprendre des capteurs de température positionnés sur la carte électronique 3 et reliés au microcontrôleur 332 de régulation de l'étage de contrôle du convertisseur, ledit microcontrôleur étant programmé, au moyen d'un algorithme approprié enregistré dans la mémoire 331, pour réaliser une boucle de régulation de la température à l'intérieur du boîtier 2. Cette boucle de régulation, compare la température mesurée par les capteurs Tm à une température de consigne To déterminée et, le cas échéant après prise en compte de valeurs de tolérance appliquée à la température To, commande l'accélération ou la décélération de l'hélice du ou des ventilateurs en fonction de l'écart de température mesuré entre To et Tm.

La présente invention a été décrite précédemment dans des modes de réalisation particuliers non limitatifs et en relation avec une application particulière également non limitative de la portée de la présente invention, laquelle s'étend au refroidissement par circulation forcée d'un fluide, liquide ou gazeux, en circuit fermé de tout type de convertisseur d'électronique de puissance pour lesquels les conditions d'utilisations peuvent être critiques à leur fonctionnement et requièrent en conséquence des indices de protection importants.

## Revendications

1. Procédé de refroidissement d'un dispositif de conversion statique d'électronique de puissance (1) comportant au moins un circuit électrique (3) comprenant un assemblage de composants actifs et de composants passifs (11, 12, 13) reliés entre eux d'une façon adaptée à la réalisation d'une fonction déterminée de conversion d'énergie électrique et supportés par une carte électronique, ledit circuit comportant des moyens d'entrée de l'énergie électrique à convertir et des moyens de sortie de l'énergie électrique convertie et étant monté dans un boîtier (2) radiateur fermé étanche duquel seuls lesdits moyens d'entrée et de sortie dudit circuit communiquent avec l'extérieur dudit boîtier, le boîtier comportant des plaques (21, 22, 23, 24) formant un fond, un capot et des parois latérales, ainsi que des flasques (25, 26) obturant les ouvertures délimitées entre les plaques aux extrémités longitudinales du boîtier, et les parois externes des plaques (21, 22, 23, 24) formant le boîtier comportant des ailettes de refroidissement (16), **caractérisé en ce que** l'on homogénéise par convection forcée la répartition de l'énergie calorifique dégagée par lesdits composants actifs et passifs dans tout le volume interne dudit boîtier et l'on transfère ladite énergie calorifique au dit boîtier radiateur par convection forcée de façon sensiblement uniforme sur toute la surface interne des parois dudit boîtier par circulation en circuit fermé d'au moins un fluide (15) contenu à l'intérieur dudit boîtier étanche, avec deux moyens de propulsion (14A, 14B) et de circulation dudit fluide disposés sensiblement au milieu de la carte électronique dans le sens de sa longueur et sur les bords latéraux de celle-ci, un cloisonnement (17) dirigé longitudinalement à l'intérieur du boîtier étant disposé entre les deux moyens de propulsion (14A, 14B) pour guider le flux d'air (15), le fluide aspiré et projeté par un premier moyen de propulsion (14A) se réfléchissant sur un premier flasque d'extrémité (25) du boîtier et étant ensuite aspiré puis projeté par le second moyen de propulsion (14B).

2. Procédé selon la revendication 1, **caractérisé en ce que** l'on canalise ledit fluide vis-à-vis desdits composants actifs et passifs et desdites parois internes du boîtier.

3. Procédé selon la revendication 1 ou 2, **caractérisé en ce que** l'on fait varier la vitesse de circulation du fluide à l'intérieur du boîtier en fonction de l'énergie calorifique dégagée par lesdits composants et/ou en fonction du volume interne dudit boîtier radiateur.

4. Procédé selon l'une des revendications 1 à 3, **caractérisé en ce que** l'on fait circuler ledit fluide entre au moins deux compartiments délimités à l'intérieur dudit boîtier.

5. Procédé selon l'une des revendications 1 à 4, **caractérisé en ce que** l'on créée des courants de fluide dans ledit boîtier, le cas échéant dans lesdits compartiments ou entre ceux-ci, de manière à augmenter la convection d'énergie calorifique vers les parois (21, 22, 23, 24, 25, 26) dudit boîtier.

6. Dispositif de conversion statique d'électronique de puissance (1), comportant au moins un circuit électrique (3) comprenant un assemblage de composants actifs et de composants passifs (11, 12, 13) reliés entre eux d'une façon adaptée à la réalisation d'une fonction déterminée de conversion d'énergie électrique et supportés par une carte électronique, ledit circuit comportant des moyens d'entrée de l'énergie électrique à convertir et des moyens de sortie de l'énergie électrique convertie et étant monté dans un boîtier (2) radiateur étanche duquel seuls lesdits moyens d'entrée et de sortie dudit assemblage communiquent avec l'extérieur dudit boîtier, le boîtier comportant des plaques (21, 22, 23, 24) formant un fond, un capot et des parois latérales, ainsi que des flasques (25, 26) obturant les ouvertures délimitées entre les plaques aux extrémités longitudinales du boîtier, et les parois externes des plaques (21, 22, 23, 24) formant le boîtier comportant des ailettes de refroidissement (16), **caractérisé en ce que** ledit boîtier renferme au moins un fluide (15) dans lequel baigne ledit assemblage de composants, et **en ce qu'**il comporte en outre deux moyens de propulsion (14A, 14B) et de circulation dudit fluide en circuit fermé à l'intérieur dudit boîtier disposés sensiblement au milieu de la carte électronique dans le sens de sa longueur et sur les bords latéraux de celle-ci, un cloisonnement (17) dirigé longitudinalement à l'intérieur du boîtier étant disposé entre les deux moyens de propulsion (14A, 14B) pour guider le flux d'air (15), le fluide aspiré et projeté par un premier moyen de propulsion (14A) se réfléchissant sur un premier flasque d'extrémité (25) du boîtier et étant ensuite aspiré puis projeté par le second moyen de propulsion (14B), les moyens de propulsion étant configurés pour homogénéiser par convection forcée la répartition de l'énergie calorifique dégagée par lesdits composants actifs et passifs dans tout le volume interne dudit boîtier et transférer ladite énergie calorifique au dit boîtier radiateur par convection forcée de façon sensiblement uniforme sur toute la surface interne des parois dudit boîtier par circulation en circuit fermé du fluide (15) contenu à l'intérieur dudit boîtier étanche.

7. Dispositif selon la revendication 6, **caractérisé en ce qu'**il comporte également le cas échéant un drain thermique entre le(s) composant(s) dudit circuit électrique et ledit boîtier.

8. Dispositif selon l'une des revendications 6 ou 7, **caractérisé en ce que** ledit fluide (15) est un liquide tel que de l'huile ou un gaz tel que de l'air apte à permettre le fonctionnement dudit circuit, ledit boîtier étant étanche au dit fluide autour dudit circuit électrique.

9. Dispositif selon l'une des revendications 6 à 8, **caractérisé en ce que** ledit moyen de propulsion (14) du fluide comporte au moins une hélice couplée à un moteur électrique relié au dit circuit électrique du dispositif.

10. Dispositif selon l'une des revendications 6 à 9, **caractérisé en ce que** la surface intérieure dudit boîtier comporte des moyens de dissipation (16) d'énergie calorifique tels que des ailettes.

## Patentansprüche

1. Verfahren zum Kühlen einer statischen Umwandlungsvorrichtung einer Leistungselektronik (1), welche mindestens eine elektrische Schaltung (3), umfassend eine Gruppe von aktiven und passiven Komponenten (11, 12, 13), die auf eine zur Ausführung einer bestimmten elektrischen Energieumwandlungsfunktion geeignete Weise miteinander verbunden sind und von einer elektronischen Karte getragen sind, wobei die Schaltung Eingangsmittel für die umzuwandelnde elektrische Energie und Ausgangsmittel für die umgewandelte elektrische Energie umfasst und montiert ist in einem dicht verschlossenen Heizkörpergehäuse (2), von dem nur die Ein- und Ausgangsmittel der Schaltung mit der Außenseite des Gehäuses verbunden sind, wobei das Gehäuse Platten (21, 22, 23, 24), die einen Boden, eine Abdeckung und Seitenwände bilden, sowie Flansche (25, 26), die die zwischen den Platten an den Längsenden des Gehäuses definierten Öffnungen abschließen, umfasst, und die Außenwände der das Gehäuse bildenden Platten (21, 22, 23, 24) Kühlrippen (16) umfassen, **dadurch gekennzeichnet, dass** die Verteilung der von den aktiven und passiven Komponenten abgegebenen Wärmeenergie durch Zwangskonvektion im ganzen Innenvolumen des Gehäuses homogenisiert wird und die Wärmeenergie dem Gehäuse zugeführt wird durch eine Zwangskonvektion, die durch die Kreislaufsgeschlossenzirkulation mindestens eines im abgedichteten Gehäuse enthaltenen Fluids (15) mit zwei Antriebs- und Zirkulationsmitteln (14A, 14B) des Fluids, die im Wesentlichen in der Mitte der elektronischen Karte in Längsrichtung und an den Seitenkanten der elektronischen Karte angeordneten sind, wobei eine Abschottung (17), die in Längsrichtung ausgerichtet ist, im Gehäuse zwischen den beiden Antriebsmitteln (14A, 14B) angeordnet ist, um den Luftstrom (15) zu führen, wobei das von einem ersten Antriebsmittel (14A) aufgesogene und abgeworfene Fluid auf einem ersten Endflansch (25) des Gehäuses zurückgeworfen und anschließend vom zweiten Antriebsmittel (14B) aufgesogen und anschließend abgeworfen wird.

2. Verfahren nach Anspruch 1, **dadurch gekennzeichnet, dass** das Fluid den aktiven und passiven Komponenten der Innenwände des Gehäuses gegenüber kanalisiert wird.

3. Verfahren nach Anspruch 1 oder 2, **dadurch gekennzeichnet, dass** die Umlaufgeschwindigkeit des Fluids im Inneren des Gehäuses als Funktion der von den Komponenten abgegebenen Wärmeenergie und/oder als Funktion des Innenvolumens des Heizkörpergehäuses variiert wird.

4. Verfahren nach einem der Ansprüche 1 bis 3, **dadurch gekennzeichnet, dass** man das Fluid zwischen mindestens zwei im Inneren des Gehäuses abgegrenzten Kammern zirkulieren lässt.

5. Verfahren nach einem der Ansprüche 1 bis 4, **dadurch gekennzeichnet, dass** man Fluidströme im Inneren des Gehäuses, ggf. im Inneren der Kammern oder zwischen diesen erzeugt, um so die Konvektion der Wärmeenergie zu erhöhen in Richtung der Wände (21, 22, 23, 24, 25, 26) des Gehäuses.

6. Statische Umwandlungsvorrichtung einer Leistungselektronik (1), welche mindestens eine elektrische Schaltung (3), umfassend eine Gruppe von aktiven und passiven Komponenten (11, 12, 13), die auf eine zur Ausführung einer bestimmten elektrischen Energieumwandlungsfunktion geeignete Weise miteinander verbunden sind, wobei die aktive und passive Komponenten von einer elektronischen Karte getragen sind, wobei die Schaltung Eingangsmittel für die umzuwandelnde elektrische Energie und Ausgangsmittel für die umgewandelte elektrische Energie umfasst und montiert ist in einem dicht verschlossenen Heizkörpergehäuse (2), von dem nur die Ein- und Ausgangsmittel der Gruppe mit der Außenseite des Gehäuses verbunden sind, wobei das Gehäuse Platten (21, 22, 23, 24), die einen Boden, eine Abdeckung und Seitenwände bilden, sowie Flansche (25, 26), die die Öffnungen abschließen, die die zwischen den Platten an den Längsenden des Gehäuses definierten sind, umfasst, und die Außenwände der Platten (21, 22, 23, 24), der das Gehäuse bilden, Kühlrippen (16) umfassen, **dadurch gekennzeichnet, dass** das Gehäuse mindestens ein Fluid (15) umfasst, in dem sich die Gruppe von Komponenten befindet, und dass es ferner umfasst: zwei Mittel (14A, 14B) zum Antrieb und zur Zirkulation des Fluids in einem geschlossenen Kreislauf im Inneren des Gehäuses, die in Längsrichtung im Wesentlichen in der Mitte der elektronischen Karte und an deren Seitenkanten angeordnet sind, wobei eine Abschottung (17), die in Längsrichtung im Gehäuse ausgerichtet ist, zwischen den beiden Antriebsmitteln (14A, 14B) angeordnet ist, um den Luftstrom (15) zu führen, wobei das Fluid, das von einem ersten Antriebsmittel (14A) aufgesogen und abgeworfen ist, auf einem ersten Endflansch (25) des Gehäuses zurückgeworfen und anschließend vom zweiten Antriebsmittel (14B) aufgesogen und anschließend abgeworfen wird, wobei die Antriebsmittel derart konfiguriert sind, dass sie durch Zwangskonvektion die Verteilung der von den aktiven und passiven Komponenten abgegebenen Energie im ganzen Innenvolumen des Gehäuses homogenisieren und dass sie die Wärmeenergie dem Heizkörpergehäuse durch Zwangskonvektion im Wesentlichen gleichmäßig über die ganze Innenfläche der Wände des Gehäuses durch Zirkulation des im abgedichteten Gehäuse enthaltenen Fluids (15) in einem geschlossenen Kreislauf übertragen.

7. Vorrichtung nach Anspruch 6, **dadurch gekennzeichnet, dass** sie ferner ggf. eine Wärmesenke zwischen der bzw. der (den) Komponente(n) der elektrischen Schaltung und dem Gehäuse umfasst.

8. Verfahren nach einem der Ansprüche 6 oder 7, **dadurch gekennzeichnet, dass** das Fluid (15) eine Flüssigkeit ist, wie z.B. Öl oder ein Gas, wie z.B. Luft, ist, und dazu geeignet ist, die Schaltung funktionieren zu lassen, wobei das Gehäuse um die elektrische Schaltung herum dem Fluid gegenüber abgedichtet ist.

9. Vorrichtung nach einem der Ansprüche 6 bis 8, **dadurch gekennzeichnet, dass** das Mittel (14) zum Antrieb des Fluids mindestens einen Propeller umfasst, der mit einem an die elektrische Schaltung der Vorrichtung angeschlossenen elektrischen Motor gekuppelt ist.

10. Vorrichtung nach einem der Ansprüche 6 bis 9, **dadurch gekennzeichnet, dass** die Innenfläche des Gehäuses Mittel (16) zur Abfuhr von Wärmeenergie, wie z.B. Rippen umfasst.

## Claims

1. A method of cooling a static power electronics conversion device (1) having at least one electrical circuit (3) comprising an assembly of active components and passive components (11, 12, 13) interconnected with each other in a way adapted to the performance of a given function of conversion of electrical energy, and supported by an electronic card, said circuit comprising means of input of electrical energy to be converted and means of output of the converted electrical energy, and being mounted in a closed sealed radiator housing (2) of which only said means of input and output of said circuit communicate with the outside of said housing, the housing comprising plates (21, 22, 23, 24) forming a bottom, a hood and side walls, as well as flanges (25, 26) closing the openings delimited between the plates at the longitudinal ends of the housing, and the outer walls of the plates (21, 22, 23, 24) forming the housing comprising cooling fins (16), **characterized in that** the distribution of the heat energy released by said active and passive components is homogenized by forced convection throughout the internal volume of said housing, and said heat energy is transferred to said radiator housing by forced convection substantially uniformly over the entire inner surface of the walls of said housing by circulation in closed circuit of at least one fluid (15) contained within said sealed housing, with two means of propulsion (14A, 14B) and circulation of said fluid disposed substantially in the middle of the electronic card in the direction of its length and on the lateral edges thereof, a partition (17) longitudinally oriented in the interior of the housing being disposed between the two means of propulsion (14A, 14B) for guiding the flow of air (15), the fluid sucked and projected by a first means of propulsion (14A) reflecting on a first end flange (25) of the housing and then being sucked and projected by the second propulsion means (14B).

2. Method according to claim 1, **characterized in that** said fluid is channeled vis-à-vis said active and passive components and said inner walls of the housing.

3. Method according to claim 1 or 2, **characterized in that** one varies the flow rate of the fluid inside the housing as a function of the heat energy released by said components and / or as a function of the internal volume of said radiator housing.

4. Method according to one of claims 1 to 3, **characterized in that** said fluid is circulated between at least two compartments delimited within said housing.

5. Method according to one of claims 1 to 4, **characterized in that** fluid streams are created in said housing, where appropriate in said compartments or between them, so as to increase heat energy convection to the walls (21, 22, 23, 24, 25, 26) of said housing.

6. A power electronic static conversion device (1), comprising at least one electrical circuit (3) comprising an assembly of active components and passive components (11, 12, 13) interconnected in a manner adapted to the performance of a specific function of conversion of electrical energy and supported by an electronic card, said circuit comprising means of input of electrical energy to be converted and means of output of the converted electrical energy and being mounted in a sealed radiator housing (2) of which only said means of input and output of said assembly communicate with the outside of said housing, the housing comprising plates (21, 22, 23, 24) forming a bottom, a hood and lateral walls, as well as flanges (25, 26) closing the openings delimited between the plates at the longitudinal ends of the housing, and the outer walls of the plates (21, 22, 23, 24) forming the housing having cooling fins (16), **characterized in that** said housing encloses at least one fluid (15) in which said assembly of components is embedded, and **in that** it further comprises two means of propulsion (14A, 14B) and circulation of said fluid in closed circuit inside said housing disposed substantially in the middle of the electronic card in the direction of its length and on the lateral edges thereof, a partition (17) longitudinally oriented inside the housing being disposed between the two means of propulsion (14A, 14B) for guiding the flow of air (15), the fluid sucked and projected by a first means of propulsion (14A) reflecting on a first end flange (25) of the housing and then being sucked and then projected by the second means of propulsion (14B), the means of propulsion being configured to homogenize the distribution of the heat energy released by the said active and passive components throughout the internal volume of said housing by forced convection and transferring said heat energy to said radiator housing by forced convection substantially uniformly over the entire inner surface of the walls of said housing by circulating the fluid (15) contained inside said sealed housing in closed circuit.

7. Device according to claim 6, **characterized in that** it also comprises, if necessary, a heat sink between the component (s) of said electrical circuit and said housing.

8. Device according to one of claims 6 or 7, **characterized in that** said fluid (15) is a liquid such as oil or a gas such as air capable of allowing the operation of said circuit, said housing being sealed to said fluid around said electrical circuit.

9. Device according to one of claims 6 to 8, **characterized in that** said means of propulsion (14) of the fluid comprises at least one propeller coupled to an electric motor connected to said electrical circuit of the device.

10. Device according to one of claims 6 to 9, **characterized in that** the inner surface of said housing comprises means (16) for dissipating heat energy such as fins.
